(19) Europäisches Patentamt / European Patent Office / Office européen des brevets

(11) **EP 4 127 749 B1**

(12) **FASCICULE DE BREVET EUROPEEN**

(45) Date de publication et mention
de la délivrance du brevet:
**08.01.2025 Bulletin 2025/02**

(21) Numéro de dépôt: **21710487.6**

(22) Date de dépôt: **11.03.2021**

(51) Classification Internationale des Brevets (IPC):
**G01R 31/378** (2019.01)    **G01R 31/387** (2019.01)
**G01R 31/367** (2019.01)

(52) Classification Coopérative des Brevets (CPC):
**G01R 31/38; G01R 31/387**; G01R 31/367;
Y02E 60/10

(86) Numéro de dépôt international:
**PCT/EP2021/056201**

(87) Numéro de publication internationale:
**WO 2021/190948 (30.09.2021 Gazette 2021/39)**

(54) **PROCEDE DE DETERMINATION EN TEMPS REEL DE LA DUREE DE VIE D'UN ELEMENT ELECTROCHIMIQUE D'UNE BATTERIE**

VERFAHREN ZUR ECHTZEITBESTIMMUNG DER LEBENSDAUER EINES ELEKTROCHEMISCHEN ELEMENTS EINER BATTERIE

METHOD FOR DETERMINING THE LIFETIME OF AN ELECTROCHEMICAL ELEMENT OF A BATTERY IN REAL TIME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.03.2020 FR 2002869**

(43) Date de publication de la demande:
**08.02.2023 Bulletin 2023/06**

(73) Titulaire: **SAFT**
**92300 Levallois-Perret (FR)**

(72) Inventeurs:
- **LAURENT, Sébastien**
  **33700 Mérignac (FR)**
- **BENJAMIN, Sébastien**
  **33850 Léognan (FR)**

- **SOURMEY, Isabelle**
  **86470 Boivre-la-Vallée (FR)**
- **CAYZAC, Romain**
  **86190 Béruges (FR)**
- **PRODHOMME, Willy**
  **86110 Amberre (FR)**
- **PAQUIN, Nicolas**
  **75017 Paris (FR)**

(74) Mandataire: **Hirsch & Associés**
**29bis, rue d' Astorg**
**75008 Paris (FR)**

(56) Documents cités:
WO-A1-2008/082288        CN-A- 103 592 605
CN-A- 109 471 036        CN-A- 110 275 115
DE-U1- 202009 000 514

**Description**

## DOMAINE TECHNIQUE

La présente invention se rapporte à un procédé de détermination en temps réel de la durée de vie d'un élément électrochimique d'une batterie. Elle trouve une application au domaine des batteries de type primaire.

## ETAT DE LA TECHNIQUE

La détermination de la durée de vie restante (ou la capacité restante, ou encore l'état de charge) d'une batterie ou pile de type primaire, telle qu'une batterie comprenant un ou plusieurs éléments électrochimiques de type Lithium primaire, par exemple de type lithium chlorure de thionyle ($LiSOCl_2$), est un problème particulièrement important dans bon nombre d'applications qui utilisent ce type de batterie ou pile, pour anticiper le remplacement d'une batterie déchargée.

On connaît des solutions de détermination de cette durée de vie restante d'une batterie qui consistent à réaliser une mesure de la tension aux bornes de la batterie et à utiliser une courbe caractéristique de tension à vide de cette batterie en fonction de son état de charge. Cependant, de telles solutions ne sont pas applicables à des éléments électrochimiques de type lithium chlorure de thionyle, car dans ce cas, la tension à vide est constante durant toute la durée de vie de la batterie et ne chute qu'en toute fin de vie. Appliquer une telle solution revient donc à pouvoir générer une alarme indiquant à l'utilisateur que la batterie doit être remplacée, en toute fin de vie de cette batterie, et donc sans possibilité réelle d'anticiper le remplacement.

On connaît également d'autres solutions de détermination de la durée de vie restante d'une batterie primaire, notamment de type $LiSOCl_2$, qui consistent également à réaliser une mesure de la tension aux bornes de cette batterie, puis à analyser la réponse en tension à une sollicitation. Cependant, ce procédé est complexe car il est basé sur une fréquence très rapide d'acquisition des données ainsi que sur une estimation très précise de l'état de passivation de la batterie. A défaut d'une fréquence suffisamment rapide et d'une estimation suffisamment précise, le résultat peut se révéler erroné. De plus, les conditions de sollicitations en tension (courant, température, ...) doivent être reproductibles pour que les résultats soient comparables. Ce procédé est donc difficile à mettre en oeuvre.

On connaît encore, du document CN103592605, un procédé de détermination de la capacité restante d'une batterie primaire de type $LiSOCl_2$ à partir d'une mesure du courant et de la température. Mais ce procédé est basé sur un calcul de perte de capacité par une méthode coulométrique (calcul des Ampèresheures déchargés) ainsi que sur une prise en compte de l'autodécharge calendaire (selon la température uniquement). Cependant cette méthode n'est pas satisfaisante car elle ne prend pas en compte les spécificités de chaque application.

On connaît également du document WO2008082288, un procédé d'estimation de la durée de vie d'une batterie dans un dispositif alimenté par batterie en fonction d'une application déterminée, le procédé comprenant la mesure d'au moins une valeur d'intensité du courant et d'au moins une valeur de température de l'élément électrochimique, et le calcul de durée de vie totale permettant de calculer le temps de disponibilité de l'élément électrochimique à partir d'un temps initial déterminé en fonction de la ou des valeurs d'intensité de courant et de la ou les valeurs de température mesurées lors de l'étape de mesure, en fonction d'une valeur déterminée de capacité de l'élément électrochimique, de la tension de coupure de l'application déterminée, et du courant de fond de l'application déterminée.

On connaît encore du document CN109471036A, un procédé d'évaluation de batterie et d'alerte précoce pour des noeuds de réseau d'un capteur, le procédé comprenant le calcul de la consommation d'un capteur, et la construction d'un modèle d'évaluation de la quantité d'électricité de la batterie sur la base d'un procédé de calcul de la consommation de la quantité d'électricité du capteur et d'un modèle d'évaluation de la quantité d'électricité de la batterie utilisée par le capteur.

On connaît encore du document CN110275115A, un procédé pour déterminer la quantité d'électricité d'une batterie, le procédé comprenant l'établissement d'une base de données de courbes de tension de décharge, la détermination du changement de la tension de la batterie pendant l'utilisation de la batterie, la comparaison des données acquises avec les courbes de tension de décharge dans la base de données et la sélection d'une courbe de tension de décharge la plus proche des données acquises.

On connaît également du document DE202009000514 (U1) un dispositif pour déterminer la puissance restante d'une batterie en unités de temps en heures et/ou minutes.

Plus généralement, les méthodes connues se basent sur l'utilisation de profils d'utilisation théoriques. Or, si l'utilisation diffère de l'attendu, l'estimation est fausse avec pour conséquences, soit de ne plus avoir d'énergie disponible pour réaliser une opération si l'utilisation a été sous-estimée, soit le remplacement prématuré d'une batterie si l'utilisation a été surestimée.

## RESUME DE L'INVENTION

Ainsi, l'invention a pour objet de résoudre notamment les problèmes précités, en proposant un procédé de détermination en temps réel de la durée de vie d'un élément électrochimique d'une batterie primaire qui soit précis, et qui prenne en compte les spécificités de chaque application.

L'invention a donc pour objet, selon un premier aspect, un procédé de détermination en temps réel de la durée de vie d'un élément électrochimique d'une batterie primaire en fonction d'une application déterminée, le procédé comprenant :

- une étape de mesure d'au moins une valeur d'intensité du courant fourni par l'élément électrochimique et d'au moins une valeur de température de l'élément électrochimique dans l'application déterminée,
- une étape de calcul de durée de vie totale permettant de calculer le temps de disponibilité de l'élément électrochimique à partir d'un temps initial déterminé, en fonction de la ou des valeurs d'intensité de courant et de la ou les valeurs de température mesurées lors de l'étape de mesure, en fonction d'une valeur déterminée de capacité de l'élément électrochimique, de la tension de coupure de l'application déterminée, et du courant de fond de l'application déterminée.

Selon les applications, le courant de fond peut représenter la consommation majoritaire d'une batterie primaire. Ce courant de fond correspond à la consommation permanente de l'électronique de l'application en question : courant de fuite de chacun des composants électroniques du système (par exemple : consommation d'un microcontrôleur en mode veille) Le procédé comprend en outre la caractéristique suivante:

- l'étape de calcul de durée de vie totale met en oeuvre le calcul du temps de disponibilité de l'élément électrochimique à partir du temps initial déterminé selon la formule $C \times Kp \times R / (Imoy + Iad)$, où :

  - $C$ correspond à la valeur déterminée de capacité de l'élément électrochimique,
  - $Kp$ correspond au coefficient de coupure de l'élément électrochimique et est fonction d'une part de l'intensité de courant maximum ($Imax$) utilisé par l'application déterminée et d'autre part de la tension de coupure ($Vc$) de l'application déterminée,
  - $Imoy$ correspond à l'intensité moyenne du courant utilisé par l'application déterminée obtenue à partir de la ou des valeurs d'intensité du courant ($I$) fourni par l'élément électrochimique, et incluant la valeur du courant de fond ($If$) de l'application déterminée,
  - $R$ correspond au rendement capacitif de l'élément électrochimique et est fonction d'une part de l'intensité moyenne $Imoy$ ou de l'intensité maximale $Imax$ du courant utilisé par l'application déterminée et d'autre part de la température de l'élément électrochimique dans l'application déterminée,
  - $Iad$ correspond à l'intensité du courant d'autodécharge de l'élément électrochimique et est fonction d'une part de l'intensité moyenne du courant ($Imoy$) utilisé par l'application déterminée et d'autre part de la température de l'élément électrochimique dans l'application déterminée;

Suivant certains modes de mise en oeuvre, le procédé comprend en outre une ou plusieurs des caractéristiques suivantes, prise(s) isolément ou suivant toutes les combinaisons techniquement possibles :

- les valeurs de $R$ et $Iad$ sont obtenues à partir de tables respectives associant des valeurs de rendement capacitif $R$, respectivement de courant d'autodécharge $Iad$, à des couples de valeurs d'intensité moyenne $Imoy$ ou d'intensité maximale $Imax$ de courant et de température ;
- la valeur de $Kp$ est obtenue à partir d'une table associant des valeurs de coefficient de coupure $Kp$ à des couples de valeurs d'intensité de courant maximum et de tension de coupure ;
- la valeur du courant de fond est obtenue par une mesure, ou est une constante paramétrable ;
- préalablement à l'étape de calcul de durée de vie totale, une étape d'enregistrement du profil de l'application déterminée est mise en oeuvre, au cours de laquelle sont enregistrées la valeur de l'intensité de courant maximum, la valeur de l'intensité de courant moyen $Imoy$, et la ou les valeurs de température mesurées à l'étape de mesure ;
- la ou les valeurs de température sont stockées dans une table en association avec des durées d'exposition correspondant aux durées pendant lesquelles l'exposition aux températures respectives a eu lieu ;
- les valeurs de température sont regroupées par seuils de température, et la table associe des durées d'exposition à des seuils de température ;
- le procédé comprend une étape de vérification de l'existence d'une demande de calcul de la durée de vie, et, si le résultat de l'étape de vérification est positif, l'étape de calcul de la durée de vie est mise en oeuvre, sinon les étapes de mesure et d'enregistrement sont successivement mises en oeuvre à nouveau ;
- le procédé comprend l'enregistrement du temps écoulé depuis le temps initial déterminé, et le calcul de la durée de vie restante de l'élément électrochimique par soustraction dudit temps écoulé à la durée de vie calculée lors de l'étape de calcul de durée de vie ;
- le procédé comprend le calcul de l'état de charge de l'élément électrochimique par division de la durée de vie restante par la durée de vie calculée lors de l'étape de calcul de durée de vie ;
- la valeur déterminée de capacité correspond à la capacité nominale de l'élément électrochimique, et le temps initial déterminé correspond au temps de fin de production de l'élément électrochimique ;

- la valeur déterminée de capacité correspond à la capacité nominale de l'élément électrochimique moins une perte de capacité durant une période déterminée, telle qu'une période de stockage, et le temps initial déterminé correspond au temps auquel l'élément électrochimique est mis en service pour la première fois et est déterminé comme étant le temps de fin de production plus la durée de la période déterminée ;

L'invention a également pour objet, selon un deuxième aspect, un produit programme d'ordinateur comprenant des instructions qui, lorsque ledit programme est exécuté par un ordinateur, conduisent ledit ordinateur à mettre en oeuvre le procédé tel que présenté ci-dessus, à partir de la mesure d'au moins une valeur d'intensité du courant fourni par l'élément électrochimique et d'au moins une valeur de température de l'élément électrochimique dans l'application déterminée.

L'invention a encore pour objet, selon un troisième aspect, un système de gestion d'un dispositif ou d'une installation comprenant une batterie, ladite batterie comprenant au moins un élément électrochimique, le système comprenant en outre :

- des moyens de mesures d'au moins une valeur d'intensité du courant fourni par l'élément électrochimique et d'au moins une valeur de température de l'élément électrochimique dans l'application déterminée de ce dit élément électrochimique ;
- des moyens électroniques ou informatiques de calcul programmés pour mettre en oeuvre le procédé tel que présenté ci-dessus, à partir de la mesure d'au moins une valeur d'intensité du courant fourni par l'élément électrochimique et d'au moins une valeur de température de l'élément électrochimique dans l'application déterminée.

L'invention a enfin pour objet, selon un quatrième aspect, une batterie comprenant au moins un élément électrochimique. La batterie comprend en outre des moyens de mesure d'au moins une valeur d'intensité du courant fourni par l'élément électrochimique et d'au moins une valeur de température de l'élément électrochimique dans une application déterminée de ce dit élément électrochimique, et des moyens électroniques de calcul programmés pour mettre en oeuvre le procédé tel que présenté ci-dessus à partir de la mesure d'au moins une valeur d'intensité du courant fourni par l'élément électrochimique et d'au moins une valeur de température de l'élément électrochimique dans l'application déterminée.

De préférence, ledit au moins un élément électrochimique est de type LiSOCl$_2$.

Ainsi, le procédé de l'invention permet de déterminer la durée de vie totale et la durée de vie restante d'une batterie primaire, en prenant en compte les spécificités de l'application dans laquelle la batterie est utilisée, donc avec une meilleure précision.

En effet, la capacité maximale, dite nominale, n'étant pas une valeur théorique constante, elle diffère selon l'application. Mais, contrairement aux solutions de l'état de l'art, le procédé de l'invention permet de recalibrer cette capacité maximale selon l'utilisation.

Par ailleurs, le procédé de l'invention prend en compte :

- le courant maximal de l'application,
- la tension de coupure de l'application,
- le courant moyen de l'application,
- la température de l'application
- le courant de fond.

Pour rappel, selon les applications, le courant de fond peut représenter la consommation majoritaire d'une batterie primaire. Ce courant de fond correspond à la consommation permanente de l'électronique de l'application en question : courant de fuite de chacun des composants électroniques du système (par exemple : consommation d'un microcontrôleur en mode veille).

## FIGURES

Les caractéristiques et avantages de l'invention apparaitront à la lecture de la description qui va suivre, donnée uniquement à titre d'exemple, et non limitative, en référence aux figures annexées suivantes :

- figure 1 : représentation schématique du procédé de l'invention selon un premier mode de mise en oeuvre ;
- figure 2 : représentation schématique plus détaillée de l'exemple de la figure 1 ;
- figure 3 : représentation schématique du procédé de l'invention selon un deuxième mode de mise en oeuvre ;
- figure 4 : représentation schématique plus détaillée de l'exemple de la figure 3 ;
- figure 5 : représentation schématique du procédé de l'invention selon un troisième mode de mise en oeuvre.

## EXPOSE DE MODES DE MISE EN OEUVRE

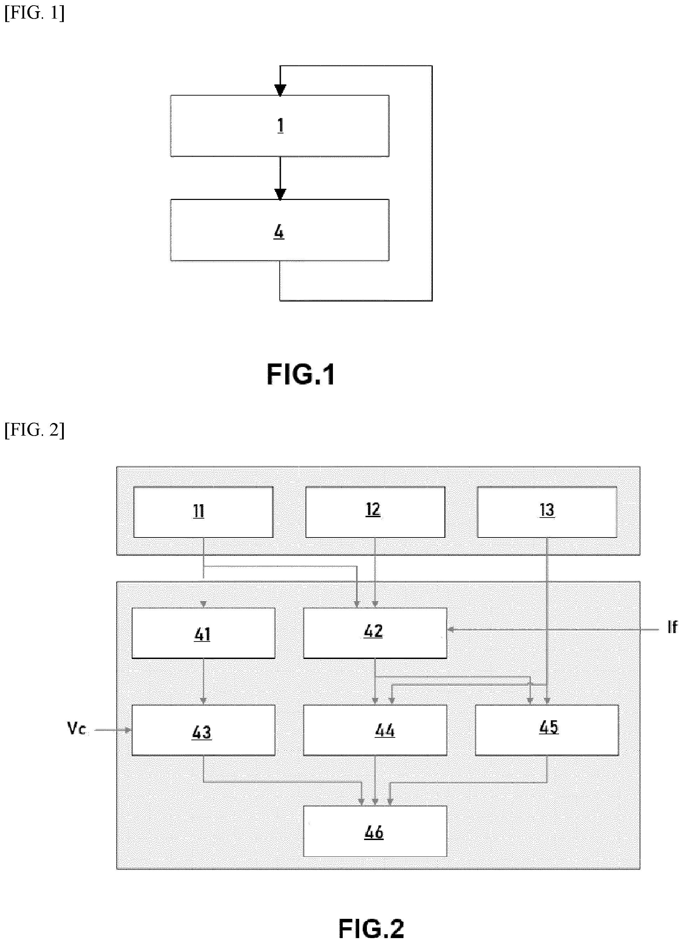

Différents modes de mise en oeuvre du procédé de l'invention sont présentés ci-après, en référence aux figures 1 à 5.

Le procédé de détermination en temps réel de la durée de vie d'un élément électrochimique d'une batterie primaire, tel qu'un élément électrochimique de type Li-SOCl$_2$, comprend une étape de mesure 1 et une étape de calcul de la durée de vie totale 4.

L'étape de mesure 1 permet de mesurer au moins une valeur d'intensité du courant I fourni par l'élément électrochimique (étape 11) et au moins une valeur de température T de l'élément électrochimique (étape 13), dans une application déterminée.

L'étape de calcul de durée de vie totale 4 permet de calculer le temps de disponibilité de l'élément électrochimique à partir d'un temps initial déterminé, en fonction de la ou des valeurs d'intensité de courant I et de la ou les valeurs de température T mesurées lors de l'étape de mesure 1, en fonction d'une valeur déterminée de capacité de l'élément électrochimique, de la tension de coupure Vc de l'application déterminée, et du courant de fond If de l'application déterminée.

Le calcul de la durée de vie totale de l'élément électrochimique, mis en oeuvre à l'étape 4, permet de calculer le temps de disponibilité de l'élément électrochimique à partir du temps initial déterminé selon la formule suivante :

$$C \times Kp \times R / (Imoy + Iad)$$

Dans cette formule :

- C correspond à la valeur déterminée de capacité de l'élément électrochimique,
- Kp correspond au coefficient de coupure de l'élément électrochimique,
- Imoy correspond à l'intensité moyenne du courant utilisé par l'application déterminée,
- R correspond au rendement capacitif de l'élément électrochimique,
- Iad correspond à l'intensité du courant d'autodécharge de l'élément électrochimique.

Le coefficient de coupure Kp de l'élément électrochimique (étape 43) est fonction d'une part de l'intensité de courant maximum Imax utilisé par l'application déterminée (obtenu à l'étape 41) et d'autre part de la tension de coupure (Vc) de l'application déterminée.

On peut obtenir la valeur de Kp à partir d'une table associant des valeurs de coefficient de coupure Kp à des couples de valeurs d'intensité de courant maximum Imax et de tension de coupure Vc.

L'intensité moyenne du courant Imoy utilisé par l'application déterminée (étape 42) est obtenue à partir de la ou des valeurs d'intensité du courant I fourni par l'élément électrochimique. Il inclut la valeur du courant de fond If de l'application déterminée.

Pour la mise en oeuvre de l'étape 42, on peut utiliser la durée écoulée depuis la précédente mise en oeuvre du procédé, préalablement déterminée à l'étape 12 dans le cadre de l'étape principale de mesure 1.

On peut obtenir la valeur du courant de fond If par exemple par une mesure. Si la valeur d'intensité du courant mesurée est inférieure à la valeur connue du courant de fond alors il est considéré que la valeur d'intensité du courant mesuré est égale à la valeur du courant de fond If. Une autre méthode pourrait être d'additionner en permanence la valeur estimée du courant de fond à la valeur d'intensité de courant de l'élément électrochimique mesurée. Alternativement, cette valeur peut être une constante paramétrable du procédé.

Le rendement capacitif R de l'élément électrochimique (étape 44) est fonction d'une part de l'intensité moyenne Imoy ou de l'intensité maximale Imax du courant utilisé par l'application déterminée et d'autre part de la température de l'élément électrochimique dans l'application déterminée.

On peut obtenir la valeur du rendement capacitif R par exemple à partir d'une table associant des valeurs de rendement capacitif R à des couples de valeurs d'intensité moyenne Imoy ou d'intensité maximale Imax de courant et de température T.

L'intensité du courant d'autodécharge Iad de l'élément électrochimique (étape 45) est fonction d'une part de l'intensité moyenne du courant Imoy utilisé par l'application déterminée et d'autre part de la température de l'élément électrochimique dans l'application déterminée.

Tout comme pour le rendement capacitif R, on peut obtenir les valeurs du courant d'autodécharge Iad par exemple à partir d'une table associant des valeurs de courant d'autodécharge Iad à des couples de valeurs d'intensité moyenne de courant Imoy et de température T.

Ainsi, une fois ces différentes valeurs obtenues, le calcul de la durée de vie de l'élément électrochimique selon la formule précédemment indiquée est effectué (étape 46).

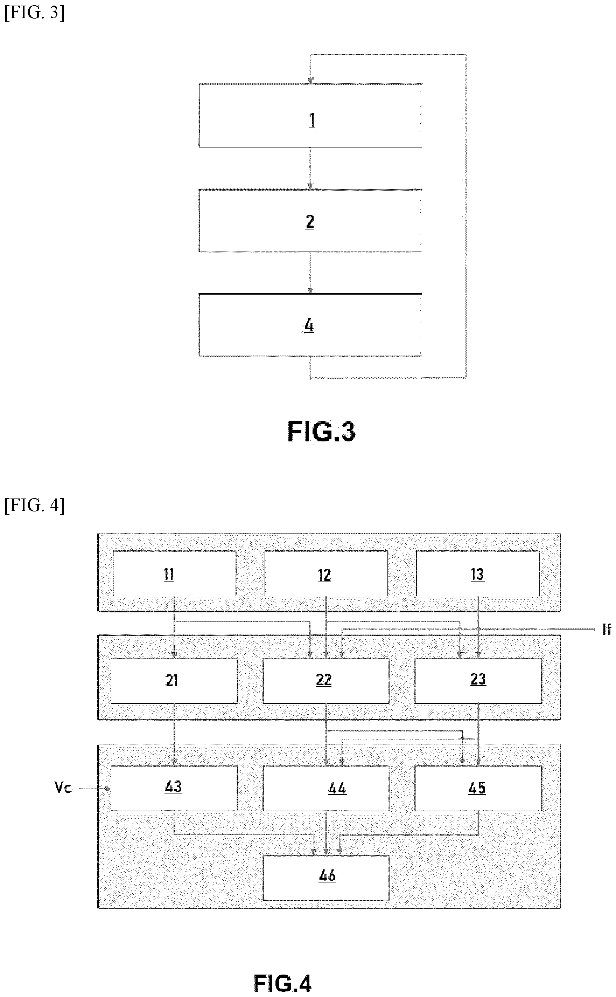

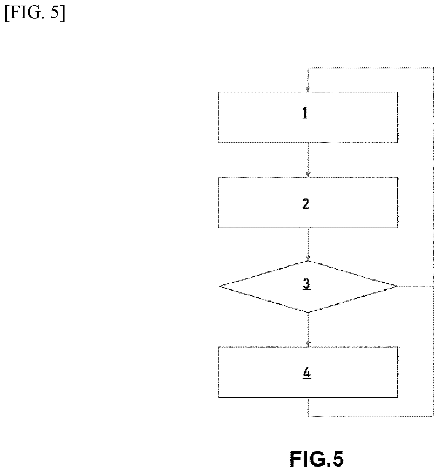

Dans les modes de mise en oeuvre particuliers représentés aux figures 3 et 5, préalablement à l'étape de calcul de durée de vie totale 4, une étape d'enregistrement du profil 2 de l'application déterminée est mise en oeuvre.

Lors de cette étape d'enregistrement du profil 2, la valeur de l'intensité de courant maximum Imax est enregistrée (étape 21) et la valeur de l'intensité de courant moyen Imoy est enregistrée (étape 22). Par ailleurs, la ou les valeurs de température T mesurées à l'étape de mesure 1, sont également enregistrées (étape 23).

Plus précisément, l'étape 23 met en oeuvre un stockage de la ou des valeurs de température T dans une table en association avec des durées d'exposition. Ces durées d'exposition correspondent aux durées pendant lesquelles l'exposition aux températures respectives T a eu lieu.

Pour la mise en oeuvre des étapes 22 et 23, on peut utiliser la durée écoulée depuis la précédente mise en oeuvre du procédé, préalablement déterminée à l'étape 12 dans le cadre de l'étape principale de mesure 1.

De préférence, on regroupe les valeurs de température T par seuils de température T. Ainsi, la table en question associe des durées d'exposition à des seuils de température T.

Dans le mode de mise en oeuvre particulier représenté à la figure 5, on prévoit de ne réaliser le calcul de la durée de vie de l'élément électrochimique que sur demande. Ainsi, une étape de vérification 3 est mise en oeuvre, au cours de laquelle on vérifie l'existence d'une demande de calcul de la durée de vie de l'élément électrochimique. Si le résultat de cette étape de vérification 3 est positif, l'étape de calcul de la durée de vie 4 est mise en oeuvre. Sinon les étapes de mesure 1 et d'enregistrement 2 sont successivement mises en oeuvre à nouveau.

Dans le cadre de la mise en oeuvre du procédé de l'invention par un ordinateur programmé à cet effet (voir explications plus loin), le mode de mise en oeuvre particulier présenté ci-dessus permet de séparer les parties mesure (étape 1) et enregistrement du profil (étape 2) peu consommatrices en termes de ressource de calcul, pour l'enregistrement en continu des données utiles liées au profil, de la partie calcul de la durée de vie (étape 4), beaucoup plus consommatrice, pour le calcul ponctuel de cette durée de vie.

On peut prévoir l'enregistrement du temps écoulé depuis le temps initial déterminé. La durée de vie restante de l'élément électrochimique peut alors être obtenue par soustraction du temps écoulé à la durée de vie calculée lors de l'étape de calcul de durée de vie 4.

On peut également calculer l'état de charge de l'élément électrochimique par division de la durée de vie restante précédemment calculée, par la durée de vie calculée lors de l'étape de calcul de durée de vie 4.

Dans le procédé de l'invention, la valeur déterminée de capacité utilisée peut correspondre à la capacité nominale de l'élément électrochimique. Le temps initial déterminé correspond alors au temps de fin de production de l'élément électrochimique.

Alternativement, la valeur déterminée de capacité utilisée dans le procédé correspond à la capacité nominale de l'élément électrochimique moins une perte de capacité durant une période déterminée. Le temps initial déterminé correspond alors au temps auquel l'élément électrochimique est mis en service pour la première fois et est déterminé comme étant le temps de fin de production plus la durée de la période déterminée. Cette période déterminée peut par exemple correspondre à une période de stockage, entre la production de l'élément électrochimique et la mise en service effective de celui-ci.

Le procédé de l'invention peut être mis en oeuvre par un ordinateur. Il est alors stocké sous formes d'instructions d'un produit programme d'ordinateur. Lorsque le programme est exécuté par l'ordinateur en question, les instructions du programme conduisent l'ordinateur à mettre en oeuvre le procédé de l'invention, à partir de la mesure d'au moins une valeur d'intensité du courant I fourni par l'élément électrochimique et d'au moins une valeur de température T de l'élément électrochimique, dans l'application déterminée.

Le procédé de l'invention peut également être mis en oeuvre par un système de gestion d'un dispositif ou d'une installation comprenant une batterie avec au moins un élément électrochimique.

Un tel système comprend classiquement des moyens électroniques ou informatiques de calculs. Il comprend en outre des moyens de mesures.

Les moyens électroniques ou informatiques de calculs sont programmés pour mettre en oeuvre le procédé de l'invention, à partir de la mesure, par les moyens de mesure, d'au moins une valeur d'intensité du courant I fourni par l'élément électrochimique et d'au moins une valeur de température T de l'élément électrochimique dans l'application déterminée.

On peut aussi prévoir que la batterie comprenne ses propres moyens de mesure, et ses propres moyens électroniques de calcul. Ces moyens électroniques de calcul sont alors programmés pour mettre en oeuvre le procédé de l'invention, à partir de la mesure, par ces moyens de mesure, d'au moins une valeur d'intensité du courant I fourni par l'élément électrochimique et d'au moins une valeur de température T de l'élément électrochimique dans l'application déterminée.

Le procédé décrit dans l'invention est applicable à toutes les électrochimies de type lithium primaire à cathode liquide, par exemple de type $LiSOCl_2$ et est également potentiellement applicable aux électrochimies lithium primaire à cathode solide, par exemple de type $LiMnO_2$ ou LiCFx.

**Revendications**

1. Procédé de détermination en temps réel de la durée de vie d'un élément électrochimique d'une batterie primaire en fonction d'une application déterminée, le procédé comprenant :

   - une étape de mesure (1) d'au moins une valeur d'intensité du courant (I) fourni par l'élément électrochimique et d'au moins une valeur de température (T) de l'élément électrochimique dans l'application déterminée,
   - une étape de calcul de durée de vie totale (4) permettant de calculer le temps de disponibilité de l'élément électrochimique à partir d'un temps initial déterminé, en fonction de la ou des valeurs d'intensité de courant (I) et de la ou les valeurs de température (T) mesurées lors de l'étape de mesure (1), en fonction d'une valeur déterminée de capacité de l'élément électrochimique, de la tension de coupure (Vc) de l'application déterminée, et du courant de fond (If) de l'application déterminée,

   **caractérisé en ce que** l'étape de calcul de durée de vie totale (4) met en oeuvre le calcul du temps de disponibilité de l'élément électrochimique à partir du temps initial déterminé selon la formule C x Kp x R / (Imoy + Iad), où :

   - C correspond à la valeur déterminée de capacité de l'élément électrochimique,

- Kp correspond au coefficient de coupure de l'élément électrochimique et est fonction d'une part de l'intensité de courant maximum (Imax) utilisé par l'application déterminée et d'autre part de la tension de coupure (Vc) de l'application déterminée,

- Imoy correspond à l'intensité moyenne du courant utilisé par l'application déterminée obtenu à partir de la ou des valeurs d'intensité du courant (I) fourni par l'élément électrochimique, et incluant la valeur du courant de fond (If) de l'application déterminée,

- R correspond au rendement capacitif de l'élément électrochimique et est fonction d'une part de l'intensité moyenne (Imoy) ou de l'intensité maximale (Imax) du courant utilisé par l'application déterminée et d'autre part de la température de l'élément électrochimique dans l'application déterminée,

- Iad correspond à l'intensité du courant d'autodécharge de l'élément électrochimique et est fonction d'une part de l'intensité moyenne du courant (Imoy) utilisé par l'application déterminée et d'autre part de la température de l'élément électrochimique dans l'application déterminée.

2. Procédé selon la revendication 1, **caractérisé en ce que** les valeurs de R et Iad sont obtenues à partir de tables respectives associant des valeurs de rendement capacitif R, respectivement de courant d'autodécharge Iad, à des couples de valeurs d'intensité moyenne Imoy ou d'intensité maximale Imax de courant et de température (T).

3. Procédé selon l'une quelconque des revendications 1 et 2, **caractérisé en ce que** la valeur de Kp est obtenue à partir d'une table associant des valeurs de coefficient de coupure Kp à des couples de valeurs d'intensité de courant maximum (Imax) et de tension de coupure (Vc).

4. Procédé selon l'une quelconque des revendications 1 à 3, **caractérisé en ce que** la valeur du courant de fond (If) est obtenue par une mesure, ou est une constante paramétrable.

5. Procédé selon l'une quelconque des revendications 1 à 4, **caractérisé en ce que** préalablement à l'étape de calcul de durée de vie totale (4), une étape d'enregistrement du profil (2) de l'application déterminée est mise en oeuvre, au cours de laquelle sont enregistrées la valeur de l'intensité de courant maximum (Imax), la valeur de l'intensité de courant moyen Imoy, et la ou les valeurs de température (T) mesurées à l'étape de mesure (1).

6. Procédé selon la revendication 5, **caractérisé en ce que** la ou les valeurs de température (T) sont stockées dans une table en association avec des durées d'exposition correspondant aux durées pendant lesquelles l'exposition aux températures respectives (T) a eu lieu.

7. Procédé selon la revendication 6, **caractérisé en ce que** les valeurs de température (T) sont regroupées par seuils de température (T), et **en ce que** la table associe des durées d'exposition à des seuils de température (T).

8. Procédé selon l'une quelconque des revendications 5 à 7, **caractérisé en ce qu'**il comprend une étape de vérification (3) de l'existence d'une demande de calcul de la durée de vie, et **en ce que**, si le résultat de l'étape de vérification (3) est positif, l'étape de calcul de la durée de vie (4) est mise en oeuvre, sinon les étapes de mesure (1) et d'enregistrement (2) sont successivement mises en oeuvre à nouveau.

9. Procédé selon l'une quelconque des revendications 1 à 8, **caractérisé en ce qu'**il comprend l'enregistrement du temps écoulé depuis le temps initial déterminé, et le calcul de la durée de vie restante de l'élément électrochimique par soustraction dudit temps écoulé à la durée de vie calculée lors de l'étape de calcul de durée de vie (4).

10. Procédé selon la revendication 9, **caractérisé en ce qu'**il comprend le calcul de l'état de charge de l'élément électrochimique par division de la durée de vie restante par la durée de vie calculée lors de l'étape de calcul de durée de vie (4).

11. Procédé selon l'une quelconque des revendication 1 à 10, **caractérisé en ce que** la valeur déterminée de capacité correspond à la capacité nominale de l'élément électrochimique, et le temps initial déterminé correspond au temps de fin de production de l'élément électrochimique.

12. Procédé selon l'une quelconque des revendication 1 à 10, **caractérisé en ce que** la valeur déterminée de capacité correspond à la capacité nominale de l'élément électrochimique moins une perte de capacité durant une période déterminée, telle qu'une période de stockage, et le temps initial déterminé correspond au temps auquel l'élément électrochimique est mis en service pour la première fois et est déterminé comme étant le temps de fin de production plus la durée de la période déterminée.

13. Produit programme d'ordinateur **caractérisé en ce qu'**il comprend des instructions qui, lorsque ledit programme est exécuté par un ordinateur, conduisent ledit ordinateur à mettre en oeuvre le procédé selon l'une quelconque des revendications 1 à 12, à partir de la mesure d'au moins une valeur d'intensité du courant (I) fourni par l'élément électrochimique et d'au moins une valeur de température (T) de l'élément électrochimique dans l'application déterminée.

14. Système de gestion d'un dispositif ou d'une installation comprenant une batterie, ladite batterie comprenant au moins un élément électrochimique, le système comprenant :

   - des moyens de mesures d'au moins une valeur d'intensité du courant (I) fourni par l'élément électrochimique et d'au moins une valeur de température (T) de l'élément électrochimique dans l'application déterminée ;

   **caractérisé en ce qu'**il comprend des moyens électroniques ou informatiques de calcul programmés pour mettre en oeuvre le procédé selon l'une quelconque des revendications 1 à 12 à partir de la mesure d'au moins une valeur d'intensité du courant (I) fourni par l'élément électrochimique et d'au moins une valeur de température (T) de l'élément électrochimique dans l'application déterminée.

15. Batterie comprenant au moins un élément électrochimique, **caractérisée en ce qu'**elle comprend en outre des moyens de mesure d'au moins une valeur d'intensité du courant (I) fourni par l'élément électrochimique et d'au moins une valeur de température (T) de l'élément électrochimique dans une application déterminée de ce dit élément électrochimique, et des moyens électroniques de calcul programmés pour mettre en oeuvre le procédé selon l'une quelconque des revendications 1 à 12 à partir de la mesure d'au moins une valeur d'intensité du courant (I) fourni par l'élément électrochimique et d'au moins une valeur de température (T) de l'élément électrochimique dans l'application déterminée

16. Batterie selon la revendication 15 dans laquelle ledit au moins un élément électrochimique est de type LiSOCl$_2$.


**Patentansprüche**

1. Verfahren zur Bestimmung der Lebensdauer einer elektrochemischen Zelle einer Primärbatterie in Echtzeit in Abhängigkeit von einer bestimmten Anwendung, wobei das Verfahren umfasst:

   - einen Schritt des Messens (1) mindestens eines Stärkewerts des Stroms (I), der von der elektrochemischen Zelle geliefert wird, und mindestens eines Temperaturwerts (T) der elektrochemischen Zelle in der bestimmten Anwendung,

   - einen Schritt des Berechnens (4) der Gesamtlebensdauer, der es ermöglicht, die Verfügbarkeitszeit der elektrochemischen Zelle auf Basis einer bestimmten Ausgangszeit zu berechnen, in Abhängigkeit von dem oder den Stromstärkewerten (I) und des oder der Temperaturwerte (T), die während des Schritts des Messens (1) gemessen wurden, in Abhängigkeit von einem bestimmten Kapazitätswert der elektrochemischen Zelle, der Abschaltspannung (Vc) der bestimmten Anwendung und des Bodenstroms (If) der bestimmten Anwendung,

   **dadurch gekennzeichnet, dass** der Schritt des Berechnens der Gesamtlebensdauer (4) das Berechnen der Verfügbarkeitszeit der elektrochemischen Zelle auf Basis der Ausgangszeit, bestimmt nach der Formel C x Kp x R/(Imoy + Iad), einsetzt, wobei:

   - C dem bestimmten Kapazitätswert der elektrochemischen Zelle entspricht,
   - Kp dem Abschaltkoeffizienten der elektrochemischen Zelle entspricht und einerseits von der maximalen Stromstärke (Imax), die von der bestimmten Anwendung verwendet wird, und andererseits von der Abschaltspannung (Vc) der bestimmten Anwendung abhängt,
   - Imoy der durchschnittlichen Stärke des von der bestimmten Anwendung verwendeten Stroms entspricht, erhalten von dem oder den Stärkewerten des von der elektrochemischen Zelle gelieferten Stroms (I), und einschließlich des Bodenstroms (If) der bestimmten Anwendung,
   - R der kapazitiven Leistung der elektrochemischen Zelle entspricht und einerseits von der durchschnittlichen Stärke (Imoy) oder der maximalen Stärke (Imax) des von der bestimmten Anwendung verwendeten Stroms und andererseits von der Temperatur der elektrochemischen Zelle in der bestimmten Anwendung abhängt,
   - Iad der Stärke des Selbstentladungsstroms der elektrochemischen Zelle entspricht und einerseits von der durchschnittlichen Stärke des Stroms (Imoy), der von der bestimmten Anwendung verwendet wird, und andererseits von der Temperatur der elektrochemischen Zelle in der bestimmten Anwendung abhängt.

2. Verfahren nach Anspruch 1, **dadurch gekennzeichnet, dass** die Werte von R und Iad aus jeweiligen Tabellen erhalten werden, die Werte einer kapazitiven Leistung R bzw. eines Selbstentladungsstroms Iad mit Wertepaaren einer durchschnittlichen Stärke Imoy oder einer maximalen Stärke Imax von Strom und Temperatur (T) verbinden.

**3.** Verfahren nach einem der Ansprüche 1 und 2, **dadurch gekennzeichnet, dass** der Wert von Kp aus einer Tabelle erhalten wird, die Werte eines Abschaltkoeffizienten Kp mit Wertepaaren einer maximalen Stromstärke (Imax) und einer Abschaltspannung (Vc) verbindet.

**4.** Verfahren nach einem der Ansprüche 1 bis 3, **dadurch gekennzeichnet, dass** der Wert des Bodenstroms (If) durch eine Messung erhalten wird oder eine parametrierbare Konstante ist.

**5.** Verfahren nach einem der Ansprüche 1 bis 4, **dadurch gekennzeichnet, dass** vor dem Schritt des Berechnens einer Gesamtlebensdauer (4) ein Schritt des Aufzeichnens des Profils (2) der bestimmten Anwendung eingesetzt wird, während dessen der Wert der maximalen Stromstärke (Imax), der Wert der durchschnittlichen Stromstärke Imoy und der oder die in dem Schritt des Messens (1) gemessenen Temperaturwerte (T) aufgezeichnet werden.

**6.** Verfahren nach Anspruch 5, **dadurch gekennzeichnet, dass** der oder die Temperaturwerte (T) in einer Tabelle in Verbindung mit Expositionszeiten, die den Zeiten, während derer die Exposition bei den jeweiligen Temperaturen (T) stattgefunden hat, entsprechen, gespeichert werden.

**7.** Verfahren nach Anspruch 6, **dadurch gekennzeichnet, dass** die Temperaturwerte (T) nach Temperaturgrenzen (T) zusammengefasst werden, und dass die Tabelle Expositionszeiten mit Temperaturgrenzen (T) verbindet.

**8.** Verfahren nach einem der Ansprüche 5 bis 7, **dadurch gekennzeichnet, dass** es einen Schritt des Überprüfens (3) des Vorhandenseins eines Antrags auf Berechnung der Lebensdauer umfasst, und dass, falls das Resultat des Überprüfungsschrittes (3) positiv ist, der Schritt des Berechnens der Lebensdauer (4) eingesetzt wird, andernfalls die Schritte des Messens (1) und Aufzeichnens (2) wieder nacheinander eingesetzt werden.

**9.** Verfahren nach einem der Ansprüche 1 bis 8, **dadurch gekennzeichnet, dass** es die Aufzeichnung der seit der bestimmten Ausgangszeit abgelaufenen Zeit und die Berechnung der Restlebensdauer der elektrochemischen Zelle durch Subtraktion der abgelaufenen Zeit von der im Schritt des Berechnens der Lebensdauer (4) berechneten Lebensdauer umfasst.

**10.** Verfahren nach Anspruch 9, **dadurch gekennzeichnet, dass** es das Berechnen des Ladezustands der elektrochemischen Zelle durch Division der Restlebensdauer durch die im Schritt des Berechnens der Lebensdauer (4) berechnete Lebensdauer umfasst.

**11.** Verfahren nach einem der Ansprüche 1 bis 10, **dadurch gekennzeichnet, dass** der bestimmte Kapazitätswert der Nominalkapazität der elektrochemischen Zelle entspricht, und die bestimmte Ausgangszeit der Zeit des Produktionsendes der elektrochemischen Zelle entspricht.

**12.** Verfahren nach einem der Ansprüche 1 bis 10, **dadurch gekennzeichnet, dass** der bestimmte Kapazitätswert der Nominalkapazität der elektrochemischen Zelle minus einem Kapazitätsverlust während einer bestimmten Periode, wie einer Speicherperiode, entspricht, und die bestimmte Ausgangszeit der Zeit entspricht, zu der die elektrochemische Zelle zum ersten Mal in Betrieb genommen wird und als die Zeit des Produktionsendes plus die Dauer der bestimmten Periode bestimmt wird.

**13.** Computerprogrammprodukt, **dadurch gekennzeichnet, dass** es Befehle umfasst, die, wenn das Programm von einem Computer ausgeführt wird, den Computer dazu veranlassen, das Verfahren nach einem der Ansprüche 1 bis 12 auf Basis des Messens mindestens eines Stärkewerts des Stroms (I), der von der elektrochemischen Zelle geliefert wird, und mindestens eines Temperaturwerts (T) der elektrochemischen Zelle in der bestimmten Anwendung einzusetzen.

**14.** System zur Steuerung einer Vorrichtung oder einer Anlage, umfassend eine Batterie, wobei die Batterie mindestens eine elektrochemische Zelle umfasst, wobei das System umfasst:

- Mittel zum Messen mindestens eines Stärkewerts des Stroms (I), der von der elektrochemischen Zelle geliefert wird, und mindestens eines Temperaturwerts (T) der elektrochemischen Zelle in der bestimmten Anwendung,

**dadurch gekennzeichnet, dass** es elektronische oder informatische Berechnungsmittel umfasst, die programmiert sind, um das Verfahren nach einem der Ansprüche 1 bis 12 auf Basis des Messens mindestens eines Stärkewerts des Stroms (I), der von der elektrochemischen Zelle geliefert wird, und mindestens eines Temperaturwerts (T) der elektrochemischen Zelle in der bestimmten Anwendung einzusetzen.

**15.** Batterie, umfassend mindestens eine elektrochemische Zelle, **dadurch gekennzeichnet, dass** sie ferner Mittel zum Messen mindestens eines Stärkewerts des Stroms (I), der von der elektrochemischen Zelle geliefert wird, und mindestens eines Temperaturwerts (T) der elektrochemischen Zelle in der bestimmten Anwendung dieser genannten elektrochemischen Zelle und elektronische Berechnungsmittel umfasst, die programmiert sind, um das Verfahren nach einem der Ansprüche 1 bis 12 auf Basis des Messens mindestens eines Stärkewerts des Stroms (I), der von der elektrochemischen Zelle geliefert wird, und mindestens eines Temperaturwerts (T) der elektrochemischen Zelle in der bestimmten Anwendung einzusetzen.

16. Batterie nach Anspruch 15, bei der die mindestens eine elektrochemische Zelle vom Typ LiSOCl$_2$ ist.

## Claims

1.  A method for real-time determination of the service life of an electrochemical cell of a primary battery as a function of a determined application, the method comprising:

    - a step of measuring (1) at least one value for current (I) supplied by the electrochemical cell and at least one temperature value (T) of the electrochemical cell in the determined application,
    - a total service life calculation step (4) for calculating availability time of the electrochemical cell starting from a determined initial time, as a function of the at least one current value (I) and the at least one temperature value (T) measured during the measurement step (1), as a function of a determined value of capacity of the electrochemical cell, cut-off voltage (Vc) for the determined application, and background current (If) for the determined application

    **characterized in that** the total service life calculation step (4) implements calculation of availability time of the electrochemical cell from the determined initial time using the formula $C \times Kp \times R/(Imoy + Iad)$, wherein:

    - C corresponds to the determined value of capacity of the electrochemical cell,
    - Kp corresponds to a cutoff coefficient of the electrochemical cell and is a function, firstly of a maximum current value (Imax) drawn by the determined application and, secondly the cut-off voltage (Vc) for the determined application,
    - Imoy corresponds to an average value of the current drawn by the determined application obtained from the one or more value(s) of the current (I) supplied by the electrochemical cell, and including the value for background current (If) for the determined application,

    - R corresponds to performance in terms of capacity of the electrochemical cell and is a function, firstly of the average value (Imoy) or the maximum value (Imax) of the current drawn by the determined application and, secondly temperature of the electrochemical cell in the determined application,
    - Iad corresponds to a value of the self-discharge current of the electrochemical cell and is a function, firstly of the average value of the current (Imoy) drawn by the determined application and, secondly temperature of the electrochemical cell in the determined application.

2.  The method according to claim 1, **characterized in that** the values of R and Iad are obtained from respective tables associating performance in terms of capacity values R, respectively self-discharge current Iad, with pairs of values representing mean Imoy or maximum Imax current and temperature (T).

3.  The method according to any one of claims 1 and 2, **characterized in that** the value of Kp is obtained from a table associating cutoff coefficient values Kp with pairs of values representing maximum current (Imax) and cut-off voltage (Vc).

4.  The method according to any one of claims 1 to 3, **characterized in that** the value for background current (If) is obtained by measurement, or is a parameterizable constant.

5.  The method according to any one of claims 1 to 4, **characterized in that** prior to the step of calculating total service life (4), a step of storing a profile (2) for the determined application is implemented, during which a value for maximum current (Imax), a value for average current Imoy, and the one or more temperature value(s) (T) measured in measuring step (1) are stored.

6.  The method according to claim 5, **characterized in that** the one or more temperature value(s) (T) are stored in a table in association with durations of exposure corresponding to durations during which exposure to the respective temperatures (T) has occurred.

7.  The method according to claim 6, **characterized in that** the temperature values (T) are grouped together by temperature thresholds (T), and **in that** the table associates durations of exposure with temperature thresholds (T).

8.  The method according to any one of claims 5 to 7, **characterized in that** it comprises a step of checking (3) for the existence of a request for calculating service life (4), and, if the result of the checking step (3) is positive, the step of calculating service life (4) is implemented, otherwise the steps of measuring (1) and storage (2) are successively carried out again.

9. The method according to any one of claims 1 to 8, **characterized in that** it comprises storing elapsed time starting from the determined initial time, and calculating the remaining service life of the electrochemical cell by subtracting said elapsed time from the service life calculated in service life calculation step (4).

10. The method according to claim 9, **characterized in that** it comprises calculating state of charge of the electrochemical cell by dividing the remaining service life by the service life calculated during service life calculation step (4).

11. The method according to any one of claims 1 to 10, **characterized in that** the determined value of capacity corresponds to the nominal capacity of the electrochemical cell, and the determined initial time corresponds to the time production of the electrochemical cell was completed.

12. The method according to any one of claims 1 to 10, **characterized in that** the determined value of capacity corresponds to the nominal capacity of the electrochemical cell minus a loss of capacity during a determined period, such as a storage period, and the determined initial time corresponds to the time at which the electrochemical cell is put into use for the first time and is determined to be the time production of the electrochemical cell was completed plus the duration of the determined period.

13. A computer program product comprising instructions which, when said program is executed by a computer, cause said computer to carry out the method according to any one of claims 1 to 12, from measuring at least one value for current ($I$) supplied by the electrochemical cell and at least one temperature value ($T$) of the electrochemical cell in the determined application.

14. A system for managing a device or installation comprising a battery, said battery comprising at least one electrochemical cell, the system comprising:

- means for measuring at least one value for current ($I$) supplied by the electrochemical cell and at least one temperature value ($T$) of the electrochemical cell in the determined application;

**characterized in that** it includes electronic or computer computing means programmed to carry out the method according to any one of claims 1 to 12 from the measurement of at least one value for current ($I$) supplied by the electrochemical cell and at least one temperature value ($T$) of the electrochemical cell in the determined application.

15. A battery comprising at least one electrochemical cell, **characterized in that** it further comprises means for measuring at least one value for current ($I$) supplied by the electrochemical cell and at least one temperature value ($T$) of the electrochemical cell in a determined application of said electrochemical cell, and electronic computing means programmed to carry out the method according to any one of claims 1 to 12 from the measurement of at least one value for current ($I$) supplied by the electrochemical cell and at least one temperature value ($T$) of the electrochemical cell in the determined application

16. The battery of claim 15 wherein said at least one electrochemical cell is of the $LiSOCl_2$ type.

[FIG. 1]

# FIG.1

[FIG. 2]

# FIG.2

[FIG. 3]

**FIG.3**

[FIG. 4]

**FIG.4**

[FIG. 5]

**FIG.5**

**RÉFÉRENCES CITÉES DANS LA DESCRIPTION**

**Documents brevets cités dans la description**

- CN 103592605
- WO 2008082288 A
- CN 109471036 A
- CN 110275115 A
- DE 202009000514 U1